(19) Europäisches Patentamt
European Patent Office
Office européen des brevets

(11) EP 3 437 855 B1

(12) **EUROPEAN PATENT SPECIFICATION**

(45) Date of publication and mention of the grant of the patent:
**20.07.2022 Bulletin 2022/29**

(21) Application number: **17775084.1**

(22) Date of filing: **28.03.2017**

(51) International Patent Classification (IPC):
***B32B 9/00*** (2006.01) ***G02F 1/1333*** (2006.01)
***H05B 33/02*** (2006.01) ***H05B 33/04*** (2006.01)
***H05B 33/14*** (2006.01) ***H01L 51/52*** (2006.01)

(52) Cooperative Patent Classification (CPC):
**H01L 51/5256; B32B 9/00; G02F 1/1333; H01L 51/50; H05B 33/04**

(86) International application number:
**PCT/JP2017/012634**

(87) International publication number:
**WO 2017/170547 (05.10.2017 Gazette 2017/40)**

(54) **GAS BARRIER LAMINATED BODY, MEMBER FOR ELECTRONIC DEVICE, AND ELECTRONIC DEVICE**

GASSPERRFILMLAMINATKÖRPER, ELEMENT FÜR EINE ELEKTRONISCHE VORRICHTUNG UND ELEKTRONISCHE VORRICHTUNG

STRATIFIÉ FORMANT BARRIÈRE AUX GAZ, ÉLÉMENT POUR DISPOSITIF ÉLECTRONIQUE ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2016 JP 2016066192**

(43) Date of publication of application:
**06.02.2019 Bulletin 2019/06**

(73) Proprietor: **LINTEC Corporation**
**Tokyo 173-0001 (JP)**

(72) Inventors:
- **NAGANAWA Satoshi**
**Tokyo 173-0001 (JP)**
- **IWAYA Wataru**
**Tokyo 173-0001 (JP)**
- **HAGIHARA Yoshiaki**
**Tokyo 173-0001 (JP)**

(74) Representative: **Adam, Holger et al**
**Kraus & Weisert**
**Patentanwälte PartGmbB**
**Thomas-Wimmer-Ring 15**
**80539 München (DE)**

(56) References cited:
**EP-A1- 2 410 005**
**WO-A1-2010/107018**
**WO-A1-2013/125351**
**JP-A- 2007 296 691**
**JP-A- 2007 296 691**
**JP-A- 2008 132 643**
**JP-A- 2011 194 587**
**JP-A- 2016 528 071**
**US-A1- 2010 019 654**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 437 855 B1

## Description

### Technical Field

The present invention relates to a gas barrier laminate that is unlikely to cause a crack even when it is bent and has an excellent gas barrier property, a member for an electronic device composed of the gas barrier laminate, and an electronic device including the member for an electronic device.

### Background Art

Recently, for displays such as a liquid crystal display and electroluminescence (EL) display, there has been used a so-called gas barrier film configured by laminating a gas barrier layer on a transparent plastic film, in place of a glass plate, as a substrate having an electrode in order to actualize thin thickness, lightweight, flexible properties and the like.

For example, in Patent Literature 1, a molded body having a gas barrier layer composed of a material containing oxygen atoms and silicon atoms is proposed.

However, there is a problem that, in a case where the molded body having a gas barrier property described in the literature is stuck to a device having a step, a crack easily occurs in the gas barrier layer and, on this occasion, the gas barrier property deteriorates and the device is easily degraded. US2010/019654 (A) and JP2007296691 (A) disclose a gas barrier laminate for electronic device.

### Citation List

#### Patent Literature

Patent Literature 1: Japanese Patent 4,921,612 (US 2012064321 A1)

### Summary of Invention

#### Technical Problem

The present invention has been achieved in consideration of the actual condition of the above-described background art, and aims at providing a gas barrier laminate that is unlikely to cause a crack even when it is bent and has an excellent gas barrier property, a member for an electronic device composed of the gas barrier laminate, and an electronic device equipped with the member for an electronic device.

#### Solution to Problem

The present inventors have intensively studied to solve the problem and resultantly found that a gas barrier laminate configured by laminating a base, a gas barrier layer and a protective layer in this order, in which each of a content rate of oxygen atoms, a content rate of nitrogen atoms and a content rate of silicon atoms relative to the total content of oxygen atoms, nitrogen atoms and silicon atoms lies in a specified range in a surface layer part on the protective layer side of the gas barrier layer and in which a Young's modulus at 25°C of the protective layer lies in a specified range, is unlikely to cause a crack in the gas barrier layer even when the gas barrier laminate is bent and has an excellent gas barrier property, to thereby complete the present invention.

#### Advantageous Effects of Invention

The gas barrier laminate of the present invention is unlikely to cause a crack even when it is bent and has an excellent gas barrier property, and the excellent gas barrier property thereof does not deteriorate over a long period of time even when it is stuck to a device having a step.

Here, the device having a step means a device in which various members for forming the device are laminated on a substrate to cause a step between the substrate and the various members.

The gas barrier laminate of the present invention is excellent in a gas barrier property and shock absorption property due to the presence of a protective layer. In other words, when the gas barrier laminate is stuck to a device, a crack or breakage is not generated to hardly deteriorate the gas barrier property.

Description of Embodiments

The gas barrier laminate of the present invention is a gas barrier laminate including a base, a gas barrier layer and a protective layer laminated directly or via another layer in this order, in which a content rate of oxygen atoms is 20 to 70%, a content rate of nitrogen atoms is 0 to 30% and a content rate of silicon atoms is 25 to 50% relative to the total content of oxygen atoms, nitrogen atoms and silicon atoms in a surface layer part on a protective layer side of the gas barrier layer; and a Young's modulus at 25°C of the protective layer is not less than $5 \times 10^9$ Pa and not more than $1 \times 10^{12}$ Pa, and at least one material comprised in the protective layer is a silicon-containing polymer compound.

(Gas barrier layer)

The gas barrier layer constituting the gas barrier laminate of the present invention is a layer having a property of suppressing transmission of a gas such as oxygen and water vapor (gas barrier property).

The gas barrier layer of the gas barrier laminate of the present invention include an inorganic vapor-deposited film, a layer obtained by subjecting a layer containing a polymer compound (hereinafter, may be referred to as a "polymer layer") to a modification treatment, and the like. Among these, in the present invention, the gas barrier layer is preferably a layer obtained by subjecting a polymer layer to a reforming treatment, which is more preferably a gas barrier unit composed of a part not having been modified of a polymer layer arranged on a base side (hereinafter, may be referred to as a "gas barrier layer (1)"), and of a layer having been subjected to modification treatment arranged on a side opposite to the base side of the gas barrier layer (1) of the polymer layer (hereinafter, may be referred to as a "gas barrier layer (2)").

The inorganic vapor-deposited films include vapor-deposited films of an inorganic compound and metal.

Raw materials of a vapor-deposited film of an inorganic compound include inorganic oxides such as silicon oxide, aluminum oxide, magnesium oxide, zinc oxide, indium oxide, tin oxide and titanium oxide; inorganic nitrides such as silicon nitride, aluminum nitride and titanium nitride; inorganic carbides; inorganic sulfides; inorganic oxynitrides such as silicon oxynitride; inorganic oxycarbides; inorganic nitridecarbides; inorganic oxynitride carbides and the like.

Raw materials of a vapor-deposited film of metal include aluminum, magnesium, zinc, tin and the like.

These can be used in one kind alone, or in two or more kinds in combination.

Among these, from the viewpoint of a gas barrier property, an inorganic vapor-deposited film derived from an inorganic oxide, inorganic nitride or metal as a raw material is preferable, and from the viewpoint of transparency in addition, an inorganic vapor-deposited film derived from an inorganic oxide or inorganic nitride as a raw material.

Methods for forming an inorganic vapor-deposited film include PVD (physical vapor deposition) methods such as a vacuum deposition method, a sputtering method and an ion plating method, and CVD methods such as a thermal CVD (chemical vapor deposition) method, a plasma CVD method and a photo-CVD method.

Thickness of an inorganic vapor-deposited film varies according to an inorganic compound to be used and, from the viewpoint of a gas barrier property and handling property, lies preferably in a range of 50 to 300 nm, and more preferably in a range of 50 to 200 nm.

Polymer compounds to be used in a gas barrier layer obtained by subjecting a polymer layer to a reforming treatment include silicon-containing polymer compounds, polyimide, polyamide, polyamide-imide, polyphenylene ether, polyether ketone, polyether ether ketone, polyolefin, polyester, polycarbonate, polysulfone, polyethersulfone, polyphenylenesulfide, polyarylate, acrylic-based resins, cycloolefin-based polymers, aromatic polymers, and the like.

These polymer compounds can be used in one kind alone, or in two or more kinds in combination.

Among these, since a gas barrier layer having a more excellent gas barrier property may be formed, silicon-containing polymer compounds are preferable as a polymer compound.

Silicon-containing polymer compounds include polysilazane-based compounds, polycarbosilane-based compounds, polysilane-based compounds, polyorganosiloxane-based compounds, and the like. Among these, since a gas barrier layer having an excellent gas barrier property can be formed even with thin thickness, polysilazane-based compounds are preferable.

Polysilazane-based compounds are polymer compounds having a repeating unit containing a -Si-N- bond (silazane bond) in a molecule. Specifically, compounds having a repeating unit represented by formula (1) are preferable.

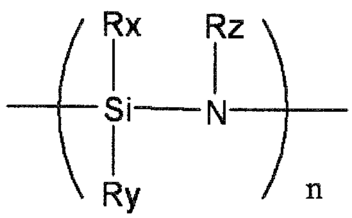

(1)

Moreover, number average molecular weight of a polysilazane-based compound to be used is not particularly limited, but is preferably 100 to 50,000.

In the formula (1), n represents an arbitrary natural number.

Rx, Ry and Rz each independently represents a hydrogen atom, or a non-hydrolyzable group such as a hydrogen atom, an unsubstituted or substituted alkyl group, an unsubstituted or substituted cycloalkyl group, an unsubstituted or substituted alkenyl group, an unsubstituted or substituted aryl group or an alkylsilyl group.

Examples of alkyl groups of the unsubstituted or substituted alkyl group include alkyl groups having 1 to 10 carbon atoms such as a methyl group, an ethyl group, an n-propyl group, an isopropyl group, an n-butyl group, an isobutyl group, a sec-butyl group, a t-butyl group, an n-pentyl group, an isopentyl group, a neopentyl group, an n-hexyl group, an n-heptyl group and a n-octyl group.

Cycloalkyl groups of the unsubstituted or substituted cycloalkyl group include cycloalkyl groups having 3 to 10 carbon atoms such as a cyclobutyl group, a cyclopentyl group, a cyclohexyl group and a cycloheptyl group.

Alkenyl groups of the unsubstituted or substituted alkenyl group include alkenyl groups having 2 to 10 carbon atoms such as a vinyl group, a 1-propenyl group, a 2-propenyl group, a 1-butenyl group, a 2-butenyl group and a 3-butenyl group.

Substituents of the alkyl group, cycloalkyl group and alkenyl group include halogen atoms such as a fluorine atom, a chlorine atom, a bromine atom and an iodine atom; a hydroxyl group; a thiol group; an epoxy group; a glycidoxy group; a (meth)acryloyloxy group; unsubstituted or substituted aryl groups such as a phenyl group, a 4-methylphenyl group and a 4-chlorophenyl group; and the like.

Examples of aryl groups of the unsubstituted or substituted aryl groups include aryl groups having 6 to 10 carbon atoms such as a phenyl group, a 1-naphthyl group and a 2-naphthyl group.

Substituents of the aryl group include halogen atoms such as a fluorine atom, a chlorine atom, a bromine atom and an iodine atom; alkyl groups having 1 to 6 carbon atoms such as a methyl group and an ethyl group; alkoxy groups having 1 to 6 carbon atoms such as a methoxy group and an ethoxy group; a nitro group; a cyano group; a hydroxyl group; a thiol group; an epoxy group; a glycidoxy group; a (meth)acryloyloxy group; unsubstituted or substituted aryl groups such as a phenyl group, a 4-methylphenyl group and a 4-chlorophenyl group; and the like.

Alkylsilyl groups include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, an ethylsilyl group, and the like.

Among these, as Rx, Ry and Rz, a hydrogen atom, an alkyl group having 1 to 6 carbon atoms or a phenyl group is preferable, and a hydrogen atom is particularly preferable.

Polysilazane-based compounds having a repeating unit represented by the formula (1) may be either inorganic polysilazane-modified in which all of Rx, Ry and Rz are hydrogen atoms or organic polysilazane in which at least one of Rx, Ry and Rz is not a hydrogen atom.

Moreover, in the present invention, a modified polysilazane product may be used as the polysilazane-based compound. Examples of modified polysilazane products include those described in Japanese Patent Laid-Open Nos. 62-195024 and 63-81122, Japanese Patent Laid-Open Nos. 2-84437, 1-138108, 2-175726, 5-238827, 5-238827, 6-122852, 6-306329, 6-299118, 9-31333, 5-345826, 4-63833, and the like.

Among these, from the viewpoint of easy availability and capability of forming an ion implantation layer having an excellent gas barrier property, perhydropolysilazane, in which all of Rx, Ry and Rz are hydrogen atoms, is preferable as the polysilazane-based compound.

Moreover, as a polysilazane-based compound, commercial products available as a glass coating material and the like can be used as is.

Polysilazane-based compounds can be used in one kind alone, or in two or more kinds in combination.

The polymer layer may contain other components in addition to above-described polymer compounds in a range that does not inhibit the purpose of the present invention. Other components include a curing agent, an anti-aging agent, a light stabilizer, a flame retardant, and the like.

The content of the polymer compound in the polymer layer is preferably not less than 50% by mass, and more preferably not less than 70% by mass, because a gas barrier layer having a more excellent gas barrier property can be obtained.

The thickness of the polymer layer is not particularly limited, but lies preferably in a range of not less than 50 nm to not more than 1 μm, more preferably in a range of 50 to 300 nm, and furthermore preferably in a range of 50 to 200 nm.

In the present invention, even when the polymer layer has nano-order thickness, a gas barrier laminate having a sufficient gas barrier property can be obtained.

A method for forming a polymer layer is not particularly limited. For example, a polymer layer can be formed by preparing a solution for forming a polymer layer, the solution containing at least one kind of the polymer compound, another components and a solvent and the like according to need, subsequently applying the solution for forming a polymer layer by a known method, and drying an obtained coating film.

Solvents for use in the solution for forming a polymer layer include aromatic hydrocarbon-based solvents such

as benzene and toluene; ester-based solvents such as ethyl acetate and butyl acetate; ketone-based solvents such as acetone, methyl ethyl ketone and methyl isobutyl ketone; aliphatic hydrocarbon-based solvents such as n-pentane, n-hexane and n-heptane; alicyclic hydrocarbon-based solvents such as cyclopentane and cyclohexane; and the like.

These solvents can be used in one kind alone, or in two or more kinds in combination.

Application methods of the solution for forming a polymer layer include a bar-coating method, a spin-coating method, a dipping method, roll coating, gravure coating, knife coating, air knife coating, roll knife coating, die coating, a screen printing method, spray coating, a gravure offset method, and the like.

As a method for drying a formed coating film, conventionally known drying methods can be employed, including hot air drying, hot roll drying, infrared ray irradiation, and the like. Heating temperature lies usually in a range of 60 to 130°C. Heating time is usually several seconds to several tens of minutes.

Reforming treatments of a polymer layer include an ion implantation treatment, a plasma treatment, an ultraviolet ray irradiation treatment, a heat treatment, and the like.

The ion implantation treatment is a method of implanting ions into a polymer layer to thereby reform the polymer layer, as described later.

The plasma treatment is a method of exposing a polymer layer in plasma to thereby reform the polymer layer. For example, the plasma treatment can be performed according to the method described in Japanese Patent Laid-Open No. 2012-106421.

The ultraviolet ray irradiation treatment is a method of irradiating a polymer layer with ultraviolet rays to thereby reform the polymer layer. For example, an ultraviolet ray reforming treatment can be performed according to the method described in Japanese Patent Laid-Open No. 2013-226757.

Among these, since a polymer layer can be reformed effectively up to the inside thereof without roughening the surface to form a gas barrier layer more excellent in a gas barrier property, the ion implantation treatment is preferable.

Ions to be implanted in a polymer layer include ions of rare gases such as argon, helium, neon, krypton and xenon; ions of fluorocarbon, hydrogen, nitrogen, oxygen, carbon dioxide, chlorine, fluorine and sulfur; ions of alkane-based gases such as methane and ethane; ions of alkene-based gases such as ethylene and propylene; ions of alkadiene-based gases such as pentadiene and butadiene; ions of alkyne-based gases such as acetylene; aromatic hydrocarbon-based gases such as benzene and toluene; ions of cycloalkane-based gases such as cyclopropane; ions of cycloalkene-based gases such as cyclopentene; ions of metals; ions of organic silicon compounds; and the like.

These ions can be used in one kind alone, or in two or more kinds in combination.

Among these, ions of rare gases such as argon, helium, neon, krypton and xenon are preferable, because these ions can be implanted in an easier and simpler way to give a gas barrier layer having a more excellent gas barrier property.

An implantation amount of ions can be suitably determined in accordance with an intended purpose (necessary gas barrier property, transparency, etc.) of a gas barrier laminate, and the like.

Implanting methods of ions include a method of irradiating a polymer layer with ions accelerated by an electric field (ion beam), a method of implanting ions in plasma, and the like. Among these, in the present invention, the latter method of implanting plasma ions is preferable because an intended barrier layer can be obtained in an easy and simple way.

Plasma ion implantation can be performed, for example, by generating plasma under an atmosphere containing a plasma generation gas such as a rare gas and applying minus voltage pulse to a polymer layer to thereby implant ions (positive ions) in the plasma into a surface layer part of the polymer layer.

Thickness of a region into which ions are to be implanted by ion implantation can be controlled by implantation conditions such as the kind of the ion, applied voltage and treatment time and may be determined in accordance with the thickness of a polymer layer, an intended purpose of a laminated body and the like, but is usually 10 to 300 nm.

In the gas barrier laminate of the present invention, a content rate of oxygen atoms is 20 to 70%, a content rate of nitrogen atoms is 0 to 30% and a content rate of silicon atoms is 25 to 50% relative to the total content of oxygen atoms, carbon atoms and silicon atoms (that is, in the case where the total of existence quantities of oxygen atoms, nitrogen atoms and silicon atoms is defined as 100%), and, from the viewpoint of causing exhibition of a more excellent gas barrier property, one in which the content rate of oxygen atoms is 15 to 65%, the content rate of nitrogen atoms is 5 to 25% and the content rate of silicon atoms is 30 to 45% is preferable, in a surface layer part on the protective layer side of the gas barrier layer.

Here, "a surface layer part on a protective layer side of a gas barrier layer" means a surface on a protective layer side of a gas barrier layer and a part of 10 nm in the depth direction from the surface. Moreover, when a gas barrier layer is the gas barrier unit, "a surface layer part on the protective layer side of the gas barrier layer (2)" corresponds to "a surface layer part on a protective layer side of a gas barrier layer."

Measurement of each content rate of oxygen atoms, nitrogen atoms and silicon atoms is performed by a method to be explained in Example.

Gas barrier layers as described above include a layer obtained by subjecting a layer containing a silicon-containing polymer compound, preferably a layer containing a polysilazane compound to a reforming treatment such as an ion implantation treatment, a plasma treatment, an ultraviolet ray irradiation treatment, a heat treatment or the like.

Furthermore, in the gas barrier laminate of the present invention, from the viewpoint of obtaining a more excellent effect of the present invention, preferably the gas barrier layer is composed of a material containing at least oxygen atoms, nitrogen atoms and silicon atoms and the content rate of oxygen atoms in the layer gradually decreases and the content rate of nitrogen atoms gradually increases, from the surface on the protective layer side of the layer toward the depth direction.

Thickness of "a region in which the content rate of oxygen atoms decreases gradually and the content rate of nitrogen atoms increases gradually, from the surface toward the depth direction" is usually 5 to 100 nm and preferably 10 to 50 nm.

Moreover, in the gas barrier laminate of the present invention, film density in a surface layer part on the protective layer side of the gas barrier layer is preferably 2.4 to 4.0 g/cm$^3$, more preferably 2.5 to 4.0 g/cm$^3$, and particularly preferably 2.6 to 4.0 g/cm$^3$.

The film density can be calculated using an X-ray reflectivity method.

When X-ray is caused to enter a thin film on a substrate at a very shallow angle, it is totally reflected. When an angle of incident X-ray becomes the total reflection critical angle or larger, the X-ray intrudes into the inside of the thin film, which is separated into transmitted waves and reflected waves, and the reflected waves interfere with each other. By analyzing the total reflection critical angle, density of the film can be obtained. Meanwhile, by performing measurement while varying an incident angle and analyzing interference signals of reflection waves on the basis of the change in optical path difference, thickness of the thin film can also be obtained.

Film density can be measured by a method described below.

It is generally known that a refractive index n of a material relative to X-ray and $\delta$ in the real part of the refractive index n satisfy following formulae 1 and 2.

$$n = 1 - \delta - i\beta$$

formula 1

$$\delta = \left(\frac{r_e \lambda^2}{2\pi}\right) N_0 \rho \sum_i x_i (Z_i + f_i') / \sum_i x_i M_i$$

formula 2

Here, $r_e$ represents the classical electron radius ($2.818 \times 10^{-15}$ m), No represents the Avogadro's number, $\lambda$ represents the wavelength of X-ray, $\rho$ represents density (g/cm$^3$), Zi, Mi and xi represent, respectively, an atomic number, an atomic weight and an atomic ratio (molar ratio) of an i-th atom, and fi' represents an atomic scattering factor (abnormal dispersion term) of the i-th atom. Moreover, the total reflection critical angle $\theta c$ is given by a formula 3, when $\beta$ relating to absorption is discounted.

$$\theta c = \sqrt{2\delta}$$

formula 3

Accordingly, from the relationship between the formula 2 and formula 3, the density $\rho$ can be obtained according to a formula 4 below.

$$\rho = \frac{\theta_c^{\,2} \sum_i x_i M_i}{\left(\frac{r_e \lambda^2}{\pi}\right) N_0 \sum_i x_i (Z_i + f_i')}$$

formula 4

Here, $\theta_C$ is a value that can be obtained from X-ray reflectivity, each of $r_e$, $N_0$ and $\lambda$ is a constant, and each of Zi, Mi and fi' is a specific value in a constituent atom. Meanwhile, regarding xi: an atomic ratio (molar ratio), a result obtained from XPS measurement is used.

The film density in a surface layer part on the protective layer side of the gas barrier layer is calculated by measuring the reflectivity for X-ray by a method to be explained in Example and using the formula 4.

Moreover, the gas barrier layer (in the case where the gas barrier layer is the gas barrier unit, the gas barrier layer (2)) preferably has a Young's modulus at 25°C of not less than $1\times10^{10}$ Pa and not more than $1\times10^{12}$ Pa, from the viewpoint of obtaining more easily the effect of the present invention.

Moreover, the Young's modulus of the gas barrier layer (in the case where the gas barrier layer is the gas barrier unit, the gas barrier layer (2)) is preferably higher than a Young's modulus of a protective layer to be described later.

As a consequence of the fact that the Young's modulus of the gas barrier layer (in the case where the gas barrier layer is the gas barrier unit, the gas barrier layer (2)) is higher than the Young's modulus of the protective layer, a crack in the gas barrier layer can be prevented even when sticking to a device having a step is performed and stress concentrates locally at the step part and the like.

A Young's modulus can be measured, for example, by the method described in Example.

In addition, in the case where a gas barrier layer is the gas barrier unit, the film density of the gas barrier layer (1) is preferably higher than film density of a protective layer to be described later.

As a consequence of the fact that the film density of the gas barrier layer (1) is higher than the film density of a protective layer to be described later, a crack in the gas barrier layer can be prevented even when sticking to a device having a step is performed and stress concentrates locally at the step part and the like.

[Protective layer]

The gas barrier laminate of the present invention has a protective layer in addition to the gas barrier layer. A Young's modulus of the protective layer is not less than $5 \times 10^9$ Pa and not more than $1 \times 10^{12}$ Pa, and preferably not less than $8 \times 10^9$ Pa and not more than $8 \times 10^{10}$ Pa.

By providing a protective layer having such Young's modulus, there can be obtained a gas barrier laminate, which is excellent in protection performance and is free from occurrence of a crack and breakage in the gas barrier layer even when a shock is given, that is, there is no possibility of deterioration of the gas barrier property due to a crack or breakage of the gas barrier layer.

At least one material to form the protective layer is a silicon-containing polymer compound. Materials to form a protective layer may further include above-described inorganic compounds, above-described vapor-deposited films of metals, acrylic-based resins, olefin-based resins, urethane-based resins, silicone-based resins, rubber-based materials, polyvinyl chloride, and the like.

Silicon-containing polymer compounds include polysilazane-based compounds, polycarbosilane-based compounds, polysilane-based compounds, polyorganosiloxane-based compounds and the like. Among these, since even a thin gas barrier layer can give an excellent gas barrier property, polysilazane-based compounds are preferable.

Acrylic-based resins include one containing at least one kind selected from homopolymers of a (meth)acrylic ester, copolymers containing two or more kinds of (meth)acrylic ester units, and copolymers of a (meth)acrylic ester and another functional monomer.

Meanwhile, "(meth)acrylic acid" means acrylic acid or methacrylic acid (the same applies hereafter).

As (meth)acrylic esters, since it is easy to set the Young's modulus of a protective layer in the above-described specific range, (meth)acrylic esters whose ester part has 1 to 20 carbon atoms are preferable, and (meth)acrylic esters whose ester part has 4 to 10 carbon atoms are more preferable.

(Meth)acrylic esters having 4 to 10 carbon atoms include butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, decyl (meth)acrylate, and the like.

A functional monomer is a monomer having a functional group such as a hydroxyl group, a carboxyl group, an amino group and an amide group. For example, there can be mentioned hydroxyl group-containing monomers such as hydroxyethyl (meth)acrylate, amide group-containing monomers such as (meth)acrylamide, carboxylic acid group-containing monomers such as (meth)acrylic acid, and the like.

Homopolymer or copolymer of (meth)acrylic ester (hereinafter, they may be collectively referred to as "(meth)acrylic ester (co)polymer") can be obtained by a known polymerization method such as a solution polymerization method, an emulsion polymerization method and a suspension polymerization method.

(Meth)acrylic ester (co)polymer can be used by mixing a crosslinking agent and forming a crosslinked body at least in a part.

Crosslinking agents include isocyanate-based crosslinking agents such as tolylenediisocyanate, hexamethylenediisocyanate and adducts thereof; epoxy-based crosslinking agents such as ethylene glycol glycidyl ether; aziridine-based crosslinking agents such as hexa[1-(2-methyl)-aziridinyl]triphosphatriazine; chelate-based crosslinking agents such as aluminum chelate; and the like.

A use amount of a crosslinking agent is, relative to solid content 100 parts by mass of (meth)acrylic ester (co)polymer, usually 0.01 to 10 parts by mass, and preferably 0.05 to 5 parts by mass. Crosslinking agents can be used in one kind alone, or in two or more kinds in combination.

Olefin-based resins include low density polyethylene, linear low density polyethylene, polypropylene, polybutene, ethylene-vinyl acetate copolymer, ethylene-(meth)acrylic acid copolymer, ethylene-(meth)acrylic ester copolymer, and the like.

Silicone-based resins include those containing dimethylsiloxane as a main component.

Rubber-based materials include those containing isoprene rubber, styrene-butadiene rubber, polyisobutylene rubber, styrene-butadiene-styrene rubber or the like as a main component.

Moreover, a protective layer may be one composed of a laminated body of layers composed of these resins.

Furthermore, a protective layer composed of such resin may be one obtained by making a thermoplastic resin into a sheet by extrusion molding, or may be one obtained by making a curable resin into a thin film by a prescribed mechanism and curing the same to form a sheet.

Examples of curable resins to be used include one obtained from a resin composition that contains an oligomer of energy-ray curable urethane acrylate or the like as a main agent, an acrylate monomer having a comparatively bulky group such as isobornyl acrylate as a diluent, and a photopolymerization initiator blended according to need.

A protective layer contains various additives, for example, other components such as an oxidation inhibitor, a tackifier, a plasticizer, an ultraviolet absorber, a coloring agent and an antistatic agent.

A method for forming a protective layer is not particularly limited, including, for example, a method of applying a protective layer-forming solution containing materials for forming the protective layer (adhesive and the like) and, according to need, another component such as a solvent onto a layer to be laminated, drying the obtained coating film and subjecting the same to heating if necessary.

Moreover, it is also possible to form, separately, a film of protective layer on a release base and to transfer and laminate the obtained film onto a layer to be laminated.

Thickness of a protective layer is usually 10 nm to 10 μm, preferably 30 nm to 1 μm, and more preferably 40 nm to 600 nm.

[Base layer]

A base layer composing the gas barrier laminate of the present invention is not particularly limited, only if it can support the gas barrier layer.

Examples of the base layer include a plate-like body, various kinds of containers and various kinds of members for an electronic device. Examples of the plate-like body include resin films, sheets and plates. Various kinds of containers include food use containers, beverage use containers, cosmetics use containers, clothing use containers, medical use containers, and bottles such as food use bottles, beverage use bottles, cooking oil bottles and seasoning bottles.

Various kinds of members for electronic devices include an organic EL element, a liquid crystal element, a quantum dot element, an electronic paper element, an organic solar cell element, a thin film battery, an organic thin film transistor element, an organic sensor element, elements for a microelectronic mechanical system (MEMS), and the like. In the present embodiment, both a sheet-type plate-like body and a long-sized plate-like body can be used as a base layer.

In the present invention, a "long size" means that the shape is belt-like in which the length in the longitudinal direction is longer than that in the width direction (preferably 10 times or longer length). In explanations below, "long-sized" may be omitted.

Among these, as a base layer, a resin film is preferable. Length (length in the longitudinal direction) of the resin film is not particularly limited, and is usually 400 to 2000 m.

The width of the resin film (length in the width direction) is not particularly limited, and is usually 450 to 1300

mm, preferably 530 to 1280 mm.

The thickness of the resin film is not particularly limited, but is usually 1 to 100 μm, preferably 5 to 70 μm, and more preferably 10 to 60 μm.

Resin components of a resin film include polyimide, polyamide, polyamide-imide, polyphenylene ether, polyether ketone, polyether ether ketone, polyolefin, polyester, polycarbonate, polysulfone, polyethersulfone, polyphenylene sulfide, acrylic-based resins, cycloolefin-based polymers, aromatic-based polymers, and the like.

These resin components can be used in one kind alone, or in two or more kinds in combination.

Among these, because of excellent transparency and versatility, polyester, polyamide, polysulfone, polyethersulfone, polyphenylene sulfide or cycloolefin-based polymers are more preferable, and polyester or cycloolefin-based polymers are furthermore preferable.

Polyesters include polyethylene terephthalate, polybutylene terephthalate, polyethylene naphthalate, polyarylate, and the like.

Cycloolefin-based polymers include norbornene-based polymers, monocyclic olefin-based polymers, cyclic conjugated diene-based polymers, vinylalicyclic hydrocarbon polymers, and hydrogenated products thereof.

The resin film may contain various kinds of additives in a range that does not hinder the effect of the present invention. Additives include an ultraviolet absorber, an antistatic agent, a stabilizer, an oxidation inhibitor, a plasticizer, a lubricant, a filler, a coloring pigment, and the like. Contents of these additives may suitably be determined in accordance with the purpose.

A resin film can be obtained by preparing a resin composition containing predetermined components and molding the same in a film shape. The molding method is not particularly limited, and known methods such as a casting method and a melt-extrusion method can be utilized.

The gas barrier laminate of the present invention is a laminated body in which the base, gas barrier layer, and protective layer are laminated directly or via another layer in this order.

Other layers include an inorganic compound layer, a conductive body layer, a primer layer, and the like.

[Primer layer]

The gas barrier laminate of the present invention may have a primer layer.

The primer layer is provided usually between the base layer and the gas barrier layer. As a consequence of providing the primer layer, irregularity in the surface of the base layer is reduced to thereby improve interlayer adhesion properties in the gas barrier laminate. Moreover, by forming the primer layer, surface roughness of the gas barrier layer can be adjusted efficiently.

Examples of primer layers include a layer composed of a cured product of an active energy ray-curable resin composition.

The active energy ray-curable resin composition is a composition that contains a polymerizable compound and is curable by irradiation of an active energy ray.

Polymerizable compounds include polymerizable prepolymers and polymerizable monomers.

Polymerizable prepolymers include polyester acrylate-based prepolymers obtained by a reaction between a polyester oligomer having hydroxyl groups at both ends and (meth)acrylic acid; epoxy acrylate-based prepolymers obtained by a reaction between a low-molecular weight bisphenol type epoxy resin or novolac type epoxy resin, and (meth)acrylic acid; urethane acrylate-based prepolymers obtained by a reaction between a polyurethane oligomer and (meth)acrylic acid; polyol acrylate-based prepolymers obtained by a reaction between polyether polyol and (meth)acrylic acid; and the like.

Polymerizable monomers include bifunctional (meth)acrylates such as 1,4-butanediol di(meth)acrylate, 1,6-hexanediol di(meth)acrylate, neopentyl glycol di(meth)acrylate, polyethylene glycol di(meth)acrylate, hydroxy pivalic acid neopentyl glycol di(meth)acrylate, dicyclopentanyl di(meth)acrylate, caprolactone-modified dicyclopentenyl di(meth)acrylate, ethyleneoxide-modified phosphoric acid di(meth)acrylate, allylated cyclohexyl di(meth)acrylate and isocyanurate di(meth)acrylate; trifunctional (meth)acrylate such as trimethylolpropane tri(meth)acrylate, pentaerythritol tri(meth)acrylate, propionic acid-modified dipentaerythritol tri(meth)acrylate, pentaerythritol tri(meth)acrylate, propyleneoxide-modified trimethylolpropane tri(meth)acrylate and tris(acryloxyethyl) isocyanurate; tetra or higher functional (meth)acrylates such as propionic acid-modified dipentaerythritol penta(meth)acrylate, dipentaerythritol hexa(meth)acrylate and caprolactone-modified dipentaerythritol hexa(meth)acrylate; vinyl compounds such as ethyleneglycol divinyl ether, pentaerythritol divinyl ether, 1,6-hexanediol divinyl ether, trimethylolpropane divinyl ether, ethyleneoxide-modified hydroquinone divinyl ether, ethyleneoxide-modified bisphenol A divinyl ether, pentaerythritol trivinyl ether, dipentaerythritol hexavinyl ether, ditrimethylolpropane polyvinyl ether: and the like, but not necessarily limited to these.

These polymerizable compounds can be used in one kind alone, or in two or more kinds in combination.

Here, the representation of a (meth)acryloyl group is intended to include both acryloyl group and methacryloyl group.

Moreover, in the active energy ray-curable resin composition, a polymer resin composition that does not have reaction curability in itself, for example, acrylic resin may be incorporated. Addition of the polymer resin component makes it possible to adjust the viscosity of the composition.

Active energy rays include ultraviolet ray, electron beam, α-ray, β-ray, γ-ray and the like. Among these, since generation using a comparatively simple apparatus is possible, ultraviolet ray is preferable as the active energy ray.

These polymerizable compounds can be used in one kind alone, or in two or more kinds in combination.

When ultraviolet ray is used as an active energy ray, an active energy ray-curable resin composition (that is, ultraviolet-curable resin composition) preferably contains a photopolymerization initiator.

A photopolymerization initiator is not particularly limited only if it initiates a polymerization reaction by irradiation of ultraviolet ray. Photopolymerization initiators include benzoin-based polymerization initiators such as benzoin, benzoin methyl ether, benzoin ethyl ether, benzoin isopropyl ether, benzoin-n-butyl ether and benzoin isobutyl ether; acetophenone-based polymerization initiators such as acetophenone, 4'-dimethylaminoacetophenone, 2,2-dimethoxy-2-phenylacetophenone, 2,2-diethoxy-2-phenylacetophenone, 2-hydroxy-2-methyl-1-phenylpropan-1 -one, 1-hydroxycyclohexyl phenyl ketone, 2-methyl-1-[4-(methylthio)phenyl]-2-morpholino-propan-1-one and 2-hydroxy-1-{4-[4-(2-hydroxy-2-methyl-propionyl) -benzyl]phenyl}-2-methyl-propan-1-one; benzophenone-based polymerization initiators such as benzophenone, 4-phenylbenzophenone, 4,4'-(diethylamino)benzophenone and 4,4'-dichlorobenzophenone; anthraquinone-based polymerization initiators such as 2-methyl anthraquinone, 2-ethyl anthraquinone, 2-t-butyl anthraquinone and 2-amino anthraquinone; thioxanthone-based polymerization initiators such as 2-methylthioxanthone, 2-ethylthioxanthone, 2-chlorothioxanthone, 2,4-dimethylthioxanthone and 2,4-diethylthioxxanthone; and the like.

A content of the photopolymerization initiator is not particularly limited, but is usually 0.2 to 30% by mass, and preferably 0.5 to 20% by mass, relative to the polymerizable compound.

An active energy ray-curable resin composition may contain fine particles such as organic fine particles and inorganic fine particles. As a consequence of using an active energy ray-curable resin composition containing fine particles, a surface of the primer layer can be made moderately rough and, as the result, formation of a gas barrier layer with a moderately rough surface can be easily formed.

Organic fine particles include fine particles composed of polystyrene-based resins, styrene-acrylic-based copolymer resins, acrylic-based resins, amino-based resins, divinylbenzene-based resins, silicone-based resins, urethane-based resins, melamine-based resins, urea resin, phenol-based resins, benzoguanamine-based resins, xylene-based resins, polycarbonate-based resins, polyethylene-based resins, polyvinyl chloride-based resins, and the like. Among these, a silicone fine particle composed of a silicone resin is preferable.

Inorganic fine particles include silica particles, metal oxide particles, alkyl silicate particles, and the like.

Silica particles include colloidal silica, hollow silica, and the like.

Metal oxide particles include particles of titanium oxide, zinc oxide, zirconium oxide, tantalum oxide, indium oxide, hafnium oxide, tin oxide, niobium oxide and the like.

Alkyl silicate particles include particles of alkyl silicate represented by a formula: $R^a$-O[-{Si($OR^b$)$_2$}-O-]$_n$-$R^a$ (where $R^a$ and $R^b$ represent an alkyl group having 1 to 10 carbon atoms, and n represents an integer of 1 or larger).

Among these, a silica particle or an alkyl silicate particle is preferable.

These fine particles can be used in one kind alone, or in two or more kinds in combination.

A shape of a fine particle is not particularly limited. For example, fine particles having various shapes such as an amorphous shape and a true spherical shape can be used.

An average particle diameter of fine particles is usually 1 to 100 nm, and preferably 1 to 20 nm. The average particle diameter of fine particles can be measured by a laser diffraction/ scattering method.

When an active energy ray-curable resin composition contains fine particles, the content of the fine particles is preferably 0.1 to 50% by mass, and more preferably 1 to 30% by mass, in the solid content of the resin composition.

An active energy ray-curable resin composition preferably contains a leveling agent. As a consequence of using an active energy ray-curable resin composition containing a leveling agent, surface roughness of a primer layer can be controlled efficiently.

Leveling agents include siloxane-based compounds. Among these, compounds having a dialkyl siloxane skeleton such as polydimethyl siloxane and derivatives thereof are preferable.

In a case where an active energy ray-curable resin composition contains the leveling agent, the content of the leveling agent is preferably 0.01 to 10% by mass, and more preferably 0.05 to 5% by mass, in the solid content of the resin composition.

An active energy ray-curable resin composition may contain other components in a range that does not hinder the effect of the present invention.

Other components include an antistatic agent, a stabilizer, an oxidation inhibitor, a plasticizer, a lubricant, a coloring pigment, and the like. Contents of these may be determined suitably in accordance with a purpose.

A method for forming a primer layer is not particularly limited. For example, by preparing a coating liquid containing an active energy ray-curable resin composition and a solvent according to need, subsequently applying the

coating liquid onto a base by a known method, and curing the obtained coating film, a hard coat layer composed of a cured product of the active energy ray-curable resin composition can be formed. Moreover, if necessary, a drying treatment may be given prior to the curing of the coating film.

Solvents for use in preparation of a coating liquid include aromatic hydrocarbon-based solvents such as benzene and toluene; ester-based solvents such as ethyl acetate and butyl acetate; ketone-based solvents such as acetone, methyl ethyl ketone and methyl isobutyl ketone; aliphatic hydrocarbon-based solvents such as n-pentane, n-hexane and n-heptane; alicyclic hydrocarbon-based solvents such as cyclopentane and cyclohexane; and the like.

These solvents can be used in one kind alone, or in two or more kinds in combination.

Application methods include a bar-coating method, a spin-coating method, a dipping method, roll coating, gravure coating, knife coating, air knife coating, roll knife coating, die coating, a screen printing method, spray coating, a gravure offset method, and the like.

In a case where a coating film is to be dried, as a method for drying the coating film, conventionally known drying methods can be employed, including hot air drying, hot roll drying, infrared ray irradiation, and the like. Drying temperature lies usually in a range of 60 to 130°C. Drying time is usually several seconds to several tens of minutes.

Curing of a coating film can be performed by irradiating the coating film with an active energy ray.

Active energy rays include ultraviolet ray, electron beam, $\alpha$-ray, $\beta$-ray, $\gamma$-ray, and the like. Among these, since generation using a comparatively simple apparatus is possible, as the active energy ray, electron beam and ultraviolet ray are preferable, and ultraviolet ray is more preferable.

When ultraviolet ray is used as the active energy ray, as a source of ultraviolet ray, light sources such as an ultra-high pressure mercury lamp, a high pressure mercury lamp, a low pressure mercury lamp, carbon arc, a black light lamp and a metal halide lamp can be used. Light intensity of ultraviolet ray is not particularly limited, but is usually 100 $mJ/cm^2$ to 1,000 $mJ/cm^2$. Irradiation time is usually several seconds to several hours, and irradiation temperature is usually 20 to 100°C.

Thickness of a primer layer is usually not more than 20 $\mu$m, preferably 0.5 to 20 $\mu$m, and more preferably 1.0 to 10 $\mu$m.

[Gas barrier laminate]

The gas barrier laminate of the present invention includes those having a layer structure of (A) or (B) below, but is not limited to these.

(A): base layer/ gas barrier layer/ protective layer
(B): base layer/ primer layer/ gas barrier layer/ protective layer

The thickness of the gas barrier laminate of the present invention is not particularly limited, and is preferably 5 to 100 $\mu$m, more preferably 10 to 50 $\mu$m, and furthermore preferably 20 to 40 $\mu$m.

A water vapor transmission rate of the gas barrier laminate of the present invention at temperature of 40°C and relative humidity of 90% is preferably not more than 0.1 $g/(m^2 \cdot day)$, more preferably not more than 0.05 $g/(m^2 \cdot day)$, and furthermore preferably not more than 0.03 $g/(m^2 \cdot day)$. There is no particular lower limit and a smaller value is more preferable, but it is usually not less than 0.001 $g/(m^2 \cdot day)$.

The water vapor transmission rate can be measured by a method described in Example.

The gas barrier laminate of the present invention has an excellent gas barrier property and, therefore, is used suitably as a member for an electronic device.

A manufacturing method of the gas barrier laminate of the present invention is not particularly limited.

For example, when a gas barrier laminate is to be formed into a long-sized gas barrier film, on a resin film for a long-sized base layer, a primer layer can be formed according to need by the above-described method, and subsequently a gas barrier layer can be formed by the above-described method, to thereby manufacture the gas barrier laminate of the present invention.

"Long-sized" means one having a length of at least around five times or larger a width of a sheet, preferably a length of ten times or larger, and for example one having a length to be wound in a roll shape and stored or conveyed.

When a primer layer is to be formed, a primer layer-forming solution may be directly applied onto a resin film for a base layer, or a primer layer may be formed by applying a primer layer-forming solution onto a process base, then superimposing a resin film for a base on the coating film and curing the coating film.

According to the manufacturing method, efficient manufacturing is possible when the gas barrier laminate of the present invention is formed in a long-sized shape.

2) Member for electronic device and electronic device

The member for an electronic device of the present invention is characterized by being composed of the gas barrier laminate of the present invention. Accordingly, the member for an electronic device of the present invention is unlikely to cause a crack even when it is bent and has an excellent gas barrier property.
The member for an electronic device of the present invention is excellent in transparency and, therefore, is suitable as a member for displays such as a liquid crystal display and EL display; and the like.
The electronic device of the present invention is equipped with the member for an electronic device of the present invention. Specific examples include a liquid crystal display, an organic EL display, an organic EL illumination, an inorganic EL display, an inorganic EL illumination, electronic paper, a solar cell and the like.

Examples

Hereinafter, the present invention is explained in more detail with reference to Examples. However, the present invention is not limited to Examples below.
In each example, "part" and "%" are based on mass, unless otherwise noted.

[Example 1]

Perhydropolysilazane ("ZNL110A-20", manufactured by AZ Electronic Materials) was applied onto a side not having been subjected to undercoat processing of a polyethylene terephthalate (PET) film ("Cosmoshine A-4100", manufactured by Toyobo Co., Ltd.) that was 50 μm in thickness and had been subjected to undercoat processing in one side, which was heated and cured at 120°C for 2 min to form a polysilazane layer. The thickness of the polysilazane layer was 200 nm.
Subsequently, plasma ions were implanted into the polysilazane layer under conditions below using a plasma ion implantation apparatus to thereby reform the surface of the polysilazane layer, and a gas barrier layer (gas barrier unit) was obtained.
Furthermore, onto the obtained gas barrier layer, the perhydropolysilazane was applied and cured at 120°C for 2 min to form a protective layer. The thickness of the protective layer was 300 nm.
For an obtained gas barrier laminate 1, various kinds of measurements were performed. Measurement results are shown in Table 1.
The plasma ion implantation apparatus and plasma ion implantation conditions used are as follows.

(Plasma ion implantation apparatus)

RF source: model "RF" 56000, manufactured by JEOL Ltd.
High voltage pulse source: "PV-3-HSHV-0835", manufactured by Kurita Manufacturing Co., Ltd.

(Plasma ion implantation conditions)

Plasma generation gas: Ar
Gas flow rate: 100 sccm
Duty ratio: 0.5%
Repetition frequency: 1000 Hz
Applied voltage: -10 kV
RF source: frequency 13.56 MHz, applied power 1000 W
Chamber inner pressure: 0.2 Pa
Pulse width: 5 μsec
Processing time (ion implantation time): 5 min

[Example 2]

The procedure in Example 1 was repeated except for setting the "applied voltage" among plasma ion implantation conditions in forming a gas barrier layer to -15 kV to obtain a gas barrier laminate 2.

[Example 3]

Example 3 is a reference example not forming part of the present invention. The procedure in Example 1 was repeated except for using, as a protective layer, a silicon dioxide layer of 300 nm deposited by a sputtering method to obtain a gas barrier laminate 3.

[Example 4]

The procedure in Example 1 was repeated except for using, as a gas barrier layer, a silicon oxynitride layer of 200 nm deposited by a sputtering method to obtain a gas barrier laminate 4.

[Comparative Example 1]

The procedure in Example 1 was repeated except for not providing a protective layer to give a gas barrier laminate 1r.

[Comparative Example 2]

The procedure in Example 1 was repeated except for forming a protective layer by applying, onto the gas barrier layer, a liquid obtained by dissolving 20 parts by mass of an acrylic-based resin [urethane acrylate-based ultraviolet ray-curable compound (SHIKOH UT-4692, manufactured by Nippon Synthetic Chemical Industry Co., Ltd.)] in 100 parts by mass of methyl isobutyl ketone and then adding a photopolymerization initiator (Irgacure127, manufactured by BASF) in 3 parts by mass relative to 100 parts by mass of solid content in the solution, drying the same at 70°C for 1 min, and subsequently performing UV light irradiation using an UV light irradiation line (high-pressure mercury lamp, line speed 20 m/min, accumulated light quantity 100 $mJ/cm^2$, peak intensity 1.466 W, pass number 2), to thereby form a gas barrier laminate 2r. The thickness of the protective layer was 300 nm.

[Comparative Example 3]

The procedure in Example 1 was repeated except for forming a protective layer by applying, onto the gas barrier layer, a liquid obtained by dissolving 20 parts by mass of an acrylic-based resin [tricylodecane dimethanol diacrylate (A-DCP, manufactured by Shin-Nakamura Chemical Co., Ltd.)] in 100 parts by mass of methyl isobutyl ketone and then adding a photopolymerization initiator (Irgacure127, manufactured by BASF) in 3 parts by mass relative to 100 parts by mass of solid content in the solution, drying the same at 70°C for 1 min, and subsequently performing UV light irradiation using an UV light irradiation line (high-pressure mercury lamp, line speed 20 m/min, accumulated light quantity 100 $mJ/cm^2$, peak intensity 1.466 W, pass number 2), to thereby form a gas barrier laminate 3r. The thickness of the protective layer was 300 nm.

For gas barrier laminates obtained in Examples and Comparative Examples, following measurements were performed.

(Measurement of water vapor transmission rate)

The water vapor transmission rate of gas barrier laminates was measured using "AQUATRAN-1" manufactured by MOCON Inc. The measurement was performed under an atmosphere of 40°C and 90% in relative humidity.

(X-ray photoelectron spectrometer)

There was performed measurement of content rates of oxygen atoms, nitrogen atoms and silicon atoms in a surface layer part of the gas barrier layer (layer obtained by performing ion implantation) under measurement conditions shown below.

Measurement apparatus: "PHI Quantera SXM", manufactured by ULVAC-PHI, INC.
X-ray source: AlKα
X-ray beam diameter: 100 μm
Power value: 25 W
Voltage: 15 kV
Extraction angle: 45°
Vacuum degree: $5.0 \times 10^{-8}$ Pa

(Measurement of thickness)

The thickness of the gas barrier laminate was measured using "Spectroellipsometry 2000U" manufactured by J. A. Woollam Co., Inc. The measurement was performed using light of 590 nm in wavelength at 23°C.

(Measurement of Young's modulus)

The Young's modulus of the gas barrier layer (1), the gas barrier layer (2) and the protective layer were measured using a micro-surface hardness tester (dynamic ultramicro-hardness tester W201S, manufactured by Shimadzu Corporation). Results are shown in Table 1.

(Durability evaluation method 1)

A durability evaluation 1 assuming an actual electronic device was performed by a method of evaluating moisture penetration on the basis of fading of metal calcium. Metal calcium was vapor deposited on a glass substrate having a step, and a sealing material (rubber-based adhesive, product name "TN-286", manufactured by MORESCO Corporation) was formed into a film so as to give 20 $\mu$m in thickness on the protective layer of the gas barrier laminate, which was stuck so as to cover the step of the glass substrate. The glass substrate has dimensions of 50 $\times$ 50 mm, and has a step having a size of 15 $\times$ 15 mm and thickness of 200 $\mu$m in the central part. After leaving at rest under an atmosphere of 23°C and 50% RH for 100 hours, a sample is observed. Cases free from fading of metal calcium were evaluated as "Good" and cases that showed fading were evaluated as "Bad". Results are shown in Table 1.

(Durability evaluation method 2)

A durability evaluation 2 was performed by a method of evaluating moisture penetration on the basis of fading of metal calcium, in the same way as durability evaluation method 1. An adhesive, (rubber-based adhesive, product name "TN-286", manufactured by MORESCO Corporation Ltd.) was formed into a film so as to give 20 $\mu$m in thickness on the protective layer of the gas barrier laminate, which was stuck with a separable film (SP-PET382150, thickness 38 $\mu$m, manufactured by Lintec Corporation) to fabricate an adhesive sheet. Metal calcium was vapor deposited on a glass substrate (product name: EAGLE XG, dimensions: 100 $\times$ 100 mm, manufactured by Corning Incorporated), and an adhesive tape was released from the release film and stuck so as to cover and seal the calcium surface. After leaving at rest under an atmosphere of 23°C and 50% RH for 100 hr, a sample is observed. Cases free from fading of metal calcium were evaluated as "Good" and cases that showed fading were evaluated as "Bad". Results are shown in Table 1.

(Measurement of film density)

Regarding the film density in the surface layer part of the gas barrier layer, reflectivity for X-ray was measured under measurement conditions shown below to obtain the total reflection critical angle $\theta c$, and from the value the film density was calculated according to the formula 4.

A measurement apparatus and measurement conditions are as follows.

Measurement apparatus: sample horizontal type X-ray diffraction apparatus for evaluating thin film "SmartLab", manufactured by Rigaku Corporation
Measurement conditions:

X-ray source; Cu-K$\alpha$1 (wavelength: 1.54059 angstrom)
optical system; parallel beam optical system
incident side slit system; Ge(220)2 crystal, height limit slit 5 mm, incident slit 0.05 mm
receiving side slit system; receiving slit 0.10 mm, solar slit 5°
detector; scintillation counter
tube voltage/ tube current; 45 kV/ 200 mA
scanning axis; $2\theta/\theta$
scanning mode; continuous scanning
scanning range; 0.1 to 3.0 deg.
scanning speed; 1 deg./min.
sampling interval; 0.002°/step

Meanwhile, as an atomic ratio (xi), each of content rates of oxygen atoms, nitrogen atoms and silicon atoms in a

surface layer part of the gas barrier layer, the percentage being obtained by an X-ray photoelectron spectroscopic measurement, was used.

TABLE 1

| | Laminate | Gas barrier unit | | | | Content rate | | | Protective layer | | Water vapor transmission rate ($g \cdot m^{-2} \cdot day^{-1}$) | Durability evaluation | |
|---|---|---|---|---|---|---|---|---|---|---|---|---|---|
| | | Gas barrier layer (1) | | Gas barrier layer (2) | | | | | | | | | |
| | | Young's modulus (GPa) | Film density ($g/cm^3$) | Young's modulus (GPa) | Film density ($g/cm^3$) | Oxygen atom (%) | Nitrogen atom (%) | Silicon atom (%) | Young's modulus (GPa) | Film density ($g/cm^3$) | | 1 | 2 |
| Example 1 | 1 | 101.6 | 1.81 | 151.2 | 2.63 | 68.1 | 2.1 | 29.8 | 103.2 | 1.59 | $8.0 \times 10^{-3}$ | Good | Good |
| Example 2 | 2 | 103.4 | 1.83 | 203.3 | 3.53 | 55.4 | 14.4 | 30.2 | 103.2 | 1.62 | $2.6 \times 10^{-3}$ | Good | Good |
| Example 3 | 3 | 87.3 | 1.83 | 151.2 | 2.66 | 68.2 | 2.2 | 29.6 | 111.5 | 2.13 | $6.1 \times 10^{-3}$ | Good | Good |
| Example 4 | 4 | - | - | 121.4 | 2.95 | 45.8 | 24.4 | 29.8 | 103.2 | 1.65 | $1.1 \times 10^{-2}$ | Good | Good |
| Comparative Example 1 | 5 | 102.3 | 1.81 | 151.1 | 2.59 | 67.6 | 2.3 | 30.1 | - | - | $8.1 \times 10^{-3}$ | Bad | Bad |
| Comparative Example 2 | 6 | 101.6 | 1.83 | 151.5 | 2.48 | 67.8 | 2.1 | 30.1 | 3.1 | 1.26 | $8.5 \times 10^{-3}$ | Bad | Bad |
| Comparative Example 3 | 7 | 101.4 | 1.82 | 151.2 | 2.74 | 68.1 | 2.1 | 29.8 | 1.9 | 1.18 | $8.5 \times 10^{-3}$ | Bad | Bad |

From Table 1, the following things are found.

In gas barrier laminates 1 to 4 in Examples 1 to 4, an elasticity modulus of the protective layer is moderate and a crack hardly occurs in the gas barrier layer even when they are bent, and deterioration of the gas barrier property has been suppressed.

On the other hand, the gas barrier laminate 1r in Comparative Example 1 is not provided with a protective layer and, therefore, bending causes a crack in the gas barrier layer to deteriorate the gas barrier property.

The gas barrier laminates 2r and 3r in Comparative Examples 2 and 3, respectively, have protective layers with a low elasticity modulus and, therefore, bending causes a crack in the gas barrier layer to deteriorate the gas barrier property.

## Claims

1. A gas barrier laminate comprising a base, a gas barrier layer and a protective layer laminated directly or via another layer in this order, wherein:

   a content rate of oxygen atoms is 20 to 70%, a content rate of nitrogen atoms is 0 to 30% and a content rate of silicon atoms is 25 to 50% relative to the total content of oxygen atoms, nitrogen atoms and silicon atoms in a surface layer part on a protective layer side of the gas barrier layer;
   a Young's modulus at 25°C of the protective layer is not less than $5 \times 10^9$ Pa and not more than $1 \times 10^{12}$ Pa; and **characterized in that**: at least one material comprised in the protective layer is a silicon-containing polymer compound.

2. The gas barrier laminate according to claim 1, wherein film density in the surface layer part on the protective layer side of the gas barrier layer is 2.4 to 4.0 g/cm$^3$.

3. The gas barrier laminate according to claim 1 or 2, wherein a Young's modulus at 25°C of the gas barrier layer is not less than $1 \times 10^{10}$ Pa and not more than $1 \times 10^{12}$ Pa.

4. The gas barrier laminate according to any one of claims 1 to 3, wherein the Young's modulus of the gas barrier layer is higher than the Young's modulus of the protective layer.

5. The gas barrier laminate according to claim 1 or 2, wherein the gas barrier layer is composed of a gas barrier unit including a gas barrier layer (1) arranged on the base side and a gas barrier layer (2) arranged on a surface side opposite to the base side of the gas barrier layer (1).

6. The gas barrier laminate according to claim 5, wherein a Young's modulus at 25°C of the gas barrier layer (2) is not less than $1 \times 10^{10}$ Pa and not more than $1 \times 10^{12}$ Pa.

7. The gas barrier laminate according to claim 5 or 6, wherein the Young's modulus of the gas barrier layer (2) is higher than the Young's modulus of the protective layer.

8. The gas barrier laminate according to any one of claims 5 to 7, wherein a film density of the gas barrier layer (1) is higher than a film density of the protective layer.

9. The gas barrier laminate according to any one of claims 1 to 8, wherein the silicon-containing polymer compound is a polymer selected from the group consisting of polysilazane-based compounds, polycarbosilane-based compounds, polysilane-based compounds, and polyorganosiloxane-based compounds.

10. A member for an electronic device composed of the gas barrier laminate according to any one of claims 1 to 9.

11. An electronic device comprising the member for electronic device according to claim 10.

## Patentansprüche

1. Gassperrlaminat, umfassend eine Basis, eine Gassperrschicht und eine Schutzschicht, die direkt oder über eine andere Schicht in dieser Reihenfolge laminiert sind, wobei:

eine Gehaltsrate von Sauerstoffatomen 20 bis 70 %, eine Gehaltsrate von Stickstoffatomen 0 bis 30 % und eine Gehaltsrate von Siliciumatomen 25 bis 50 % beträgt, bezogen auf den Gesamtgehalt an Sauerstoffatomen, Stickstoffatomen und Siliciumatomen in einem Oberflächenschichtteil auf einer Schutzschichtseite der Gassperrschicht;
der Elastizitätsmodul der Schutzschicht bei 25 °C nicht weniger als $5 \times 10^9$ Pa und nicht mehr als $1 \times 10^{12}$ Pa beträgt; und
**dadurch gekennzeichnet, dass**: mindestens ein Material, das in der Schutzschicht enthalten ist, eine silikonhaltige Polymerverbindung ist.

2. Gassperrlaminat nach Anspruch 1, wobei die Filmdichte im Oberflächenschichtteil auf der Schutzschichtseite der Gassperrschicht 2,4 bis 4,0 g/cm$^3$ beträgt.

3. Gassperrlaminat nach Anspruch 1 oder 2, wobei der Elastizitätsmodul der Gassperrschicht bei 25°C nicht weniger als $1 \times 10^{10}$ Pa und nicht mehr als $1 \times 10^{12}$ Pa beträgt.

4. Gassperrlaminat nach einem der Ansprüche 1 bis 3, wobei der Elastizitätsmodul der Gassperrschicht höher ist als der Elastizitätsmodul der Schutzschicht.

5. Gassperrlaminat nach Anspruch 1 oder 2, wobei die Gassperrschicht aus einer Gassperreinheit besteht, die eine auf der Basisseite angeordnete Gassperrschicht (1) und eine auf einer der Basisseite der Gassperrschicht (1) gegenüberliegenden Oberflächenseite angeordnete Gassperrschicht (2) umfasst.

6. Gassperrlaminat nach Anspruch 5, wobei der Elastizitätsmodul bei 25°C der Gassperrschicht (2) nicht weniger als $1 \times 10^{10}$ Pa und nicht mehr als $1 \times 10^{12}$ Pa beträgt.

7. Gassperrlaminat nach Anspruch 5 oder 6, wobei der Elastizitätsmodul der Gassperrschicht (2) höher ist als der Elastizitätsmodul der Schutzschicht.

8. Gassperrlaminat nach einem der Ansprüche 5 bis 7, wobei die Filmdichte der Gassperrschicht (1) höher ist als die Filmdichte der Schutzschicht.

9. Gassperrlaminat nach einem der Ansprüche 1 bis 8, wobei die silikonhaltige Polymerverbindung ein Polymer ist, das aus der Gruppe ausgewählt ist, die aus Verbindungen auf Polysilazanbasis, Verbindungen auf Polycarbosilanbasis, Verbindungen auf Polysilanbasis und Verbindungen auf Polyorganosiloxanbasis besteht.

10. Element für ein elektronisches Gerät, das aus dem Gassperrlaminat nach einem der Ansprüche 1 bis 9 besteht.

11. Elektronisches Gerät, das das Element für ein elektronisches Gerät nach Anspruch 10 umfasst.

## Revendications

1. Stratifié de barrière aux gaz comprenant une base, une couche de barrière aux gaz et une couche protectrice stratifiée directement ou via une autre couche dans cet ordre, dans lequel :

un taux de contenu d'atomes d'oxygène est de 20 à 70 %, un taux de contenu d'atomes d'azote est de 0 à 30 % et un taux de contenu d'atomes de silicium est de 25 à 50 % par rapport au contenu total d'atomes d'oxygène, d'atomes d'azote et d'atomes de silicium dans une partie de couche de surface sur un côté de couche protectrice de la couche barrière aux gaz ;
un module de Young à 25°C de la couche protectrice n'est pas inférieur à $5 \times 10^9$ Pa et pas supérieur à $1 \times 10^{12}$ Pa ; et
**caractérisé en ce que** : au moins un matériau compris dans la couche protectrice est un composé polymère contenant du silicium.

2. Stratifié de barrière aux gaz selon la revendication 1, dans lequel la densité du film dans la partie de la couche de surface du côté de la couche protectrice de la couche de barrière aux gaz est de 2,4 à 4,0 g/cm$^3$.

3. Stratifié de barrière aux gaz selon la revendication 1 ou 2, dans lequel un module de Young à 25°C de la couche

de barrière aux gaz n'est pas inférieur à 1 $\times$ $10^{10}$ Pa et n'est pas supérieur à 1 $\times$ $10^{12}$ Pa.

**4.** Stratifié de barrière aux gaz selon l'une quelconque des revendications 1 à 3, dans lequel le module de Young de la couche de barrière aux gaz est supérieur au module de Young de la couche protectrice.

**5.** Stratifié de barrière aux gaz selon la revendication 1 ou 2, dans lequel la couche de barrière aux gaz est composée d'une unité de barrière aux gaz comprenant une couche de barrière aux gaz (1) disposée sur le côté de base et une couche de barrière aux gaz (2) disposée sur un côté de surface opposé au côté de base de la couche de barrière aux gaz (1).

**6.** Stratifié de barrière aux gaz selon la revendication 5, dans lequel un module de Young à 25°C de la couche de barrière aux gaz (2) n'est pas inférieur à 1 $\times$ $10^{10}$ Pa et pas supérieur à 1 $\times$ $10^{12}$ Pa.

**7.** Stratifié de barrière aux gaz selon la revendication 5 ou 6, dans lequel le module de Young de la couche de barrière aux gaz (2) est supérieur au module de Young de la couche protectrice.

**8.** Stratifié de barrière aux gaz selon l'une quelconque des revendications 5 à 7, dans lequel une densité de film de la couche de barrière aux gaz (1) est supérieure à une densité de film de la couche protectrice.

**9.** Stratifié de barrière aux gaz selon l'une quelconque des revendications 1 à 8, dans lequel le composé polymère contenant du silicium est un polymère choisi dans le groupe constitué par les composés à base de polysilazane, les composés à base de polycarbosilane, les composés à base de polysilane et les composés à base de polyorganosiloxane.

**10.** Élément pour un dispositif électronique composé du stratifié barrière aux gaz selon l'une quelconque des revendications 1 à 9.

**11.** Dispositif électronique comprenant l'élément pour un dispositif électronique selon la revendication 10.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2010019654 A
- JP 2007296691 A
- JP 4921612 B
- US 2012064321 A1
- JP 62195024 A
- JP 63081122 A
- JP 2084437 A
- JP 1138108 A
- JP 2175726 A
- JP 5238827 A
- JP 6122852 A
- JP 6306329 A
- JP 6299118 A
- JP 9031333 A
- JP 5345826 A
- JP 4063833 A
- JP 2012106421 A
- JP 2013226757 A